# EUROPÄISCHE PATENTSCHRIFT

(11) **EP 2 947 054 B1**
(45) Veröffentlichungstag und Bekanntmachung des Hinweises auf die Patenterteilung: **11.01.2017**
(21) Anmeldenummer: 14001805.2
(22) Anmeldetag: 22.05.2014
(51) Int. Cl.: C03B 5/42, C03B 5/43, F27D 1/00, C03B 5/08, C03B 17/04

(54) **BAUTEIL, INSBESONDERE FÜR DEN EINSATZ IN EINEM TIEGELZIEHVERFAHREN FÜR QUARZGLAS UND VERFAHREN ZUR HERSTELLUNG EINES DERARTIGEN BAUTEILS**
COMPONENT, IN PARTICULAR FOR USE IN A CZOCHRALSKI METHOD FOR QUARTZ GLASS AND METHOD FOR PRODUCING SUCH A COMPONENT
COMPOSANT, NOTAMMENT DESTINÉ À ÊTRE UTILISÉ DANS UN PROCÉDÉ D'ÉTIRAGE EN CREUSET POUR VERRE À QUARTZ ET PROCÉDÉ DE FABRICATION D'UN TEL COMPOSANT

(43) Veröffentlichungstag der Anmeldung: 25.11.2015
(73) Patentinhaber: Heraeus Quarzglas GmbH & Co. KG, 63450 Hanau (DE)
(72) Erfinder: Gromann, Boris, 63743 Aschaffenburg (DE); Whippey, Nigel, 63500 Sellgenstadt (DE); Schenk, Christian, 55218 Ingelheim (DE)
(74) Vertreter: Staudt, Armin Walter

(56) Entgegenhaltungen:
- WO-A1-2007/105550
- DE-A1-102005 061 274
- GB-A- 339 268
- NL-C- 2 003 916
- US-A1- 2011 281 227
- US-B1- 6 422 861
- US-B1- 6 632 086
- US-B1- 6 739 155

## Beschreibung

Die vorliegende Erfindung betrifft ein Verfahren zur Herstellung eines Bauteils durch Fügen von Wandteilen - insbesondere zur Herstellung eines Schmelztiegels für den Einsatz bei hoher Arbeitstemperatur in einem Tiegelziehverfahren für Quarzglas -, indem mindestens zwei Wandteile aus einem Refraktärmetall oder aus einer Basislegierung eines Refraktärmetalls bereitgestellt, unter Bildung einer Fuge auf Stoß aneinander gesetzt und bei einer Temperatur oberhalb von 1500°C zu dem Bauteil durch Sintern zusammen gefügt werden.

Weiterhin betrifft die Erfindung ein Bauteil, insbesondere einen Schmelztiegel, insbesondere in einem Tiegelziehverfähren für Quarzglas, das mindestens zwei Wandteile aus einem Refraktärmetall oder aus einer Basislegierung eines Refraktärmetalls aufweist, welche unter Bildung einer Fuge auf Stoß aneinander gesetzt sind.

### Stand der Technik

Für die Herstellung zylinderförmiger Bauteile aus Quarzglas mit beliebigem Querschnittsprofil sind Tiegelziehverfahren gebräuchlich. Die dabei eingesetzten Tiegel bestehen aus Refraktärmetallen, die unter anderem die Gruppe der Metalle Hafnium (Hf), Niob (Nb), Tantal (Ta), Molybdän (Mo) und Wolfram (W) umfasst. In der Regel werden Tiegel aus Wolfram eingesetzt. Daneben ist als Tiegel-Werkstoff für die Wandteile auch Molybdän (Mo) gebräuchlich, oder Basislegierungen von Wolfram und Molybdän. Eine Basislegierung im Sinne der Erfindung ist eine Legierung mit einem Anteil des Basiselementes von mindestens 50 Gew.-%. Die refraktären Metalle oder Legierungen dieser Metalle sind allerdings gegenüber geschmolzenem Quarzglas nicht vollkommen korrosionsbeständig und reagieren bei hohen Temperaturen mit Sauerstoff aus dem Quarzglas. Dabei bilden sich Metalloxide, die sich an der Tiegelwandung und im Bodenbereich des Schmelztiegels anreichern, von wo sie von Zeit zu Zeit mit dem Schmelzfluss der Glasschmelze in konzentrierter Form abgezogen werden und sich dann als Schlieren oder Verfärbungen des Quarzglasstrangs bemerkbar machen und ebenso zu Ausschuss führen, wie nicht gelöste Metalloxidpartikel in der Quarzglasschmelze. Die Schmelztiegel sind aus einzelnen Wandteilen zusammengesetzt, die mit möglichst hoher Passgenauigkeit gefertigt sind. Die Wandteile werden auf Stoß zusammengesetzt und versintern während des Schmelzbetriebs. Dabei wird jedoch keine Gasdichtigkeit erreicht, was zu Blaseneinschlüssen in der Quarzglasschmelze führt. Darüber hinaus wird ein korrosiver Angriff auch von außen an den Stoßstellen der Wandteile durch verunreinigte oder feuchte Gase beobachtet, was den Eintrag vom Refraktärmetall, in der Regel von Wolfram, in die Schmelze begünstigt.

Schmelztiegel aus hochschmelzenden Metallen der Gruppe Iridium, Rhenium, Osmium und Ruthenium zeigen zwar eine wesentlich bessere Korrosionsbeständigkeit gegenüber einer Quarzglasschmelze, sie sind jedoch sehr teuer. Die Ausbildung eines Schmelztiegels aus Iridium wird beispielsweise in der JP 02-022132 A vorgeschlagen.

Alternativ dazu bietet es sich an, lediglich auf der Innenseite eines ansonsten aus Wolfram oder Molybdän bestehenden Schmelztiegels eine Schutzschicht aus Metallen der Gruppe Iridium, Rhenium, Osmium und Ruthenium aufzubringen. Schmelztiegel dieser Art sind beispielsweise aus der US 6,632,086 B1, der US 6,422,861 B1 und aus der US 6,739,155 B1 bekannt. Darin wird vorgeschlagen, die Tiegel-Innenseite mit Schutzschichten aus Iridium, Rhenium, Osmium oder Legierungen dieser Beschichtungsmetalle zu versehen. Die Schutzschicht ist dabei entweder mit der Tiegelwandung metallurgisch verbunden oder sie bildet ein separates Einsatzteil, das an der Tiegelwandung anliegt und an dieser mechanisch fixiert ist.

Die zuletzt beschriebenen Schmelztiegel weisen eine verbesserte Korrosionsbeständigkeit gegenüber Quarzglasschmelzen auf. Die Materialkosten für die Herstellung der Tiegel sind wegen der teuren Beschichtungsmetalle für die Herstellung der Schutzschicht jedoch sehr hoch. Außerdem kann selbst mit der inneren Beschichtung keine ausreichende Gasdichtigkeit der Tiegelwandung erreicht werden.

### Technische Aufgabenstellung

Ausgehend von diesem Stand der Technik liegt der Erfindung die Aufgabe zugrunde, ein Bauteil für den Einsatz in einem Tiegelziehverfahren für Quarzglas mit verbesserter Dichtigkeit bereitzustellen und ein Verfahren zur Herstellung eines derartigen Bauteils anzugeben.

### Allgemeine Beschreibung der Erfindung

Hinsichtlich des Verfahrens wird diese Aufgabe ausgehend von einem Verfahren der eingangs genannten Gattung erfindungsgemäß dadurch gelöst, dass ein Dichtmittel in die Fuge eingefügt wird.

Beim erfindungsgemäßen Verfahren ist es vorgesehen, dass nachdem die einzelnen Wandteile möglichst passgenau auf Stoß aneinander gesetzt sind in die sich bildende Fuge zwischen den Wandteilen ein Dichtmittel eingefügt wird. Die so verbundenen Wandteile werden dann bei einer Temperatur oberhalb von 1500°C zu einem Bauteil versintert. Das Dichtmittel wirkt als Sinterhilfsmittel und sorgt dafür, dass die Fuge zwischen den Wandungen der Einzelteile sich beim Versintern gasdicht verschließt. Durch das Dichtmittel kann die Dauer für die Versinterung gekürzt werden, was wirtschaftlich von Nutzen ist. Bauteile, die nach dem erfindungsgemäßen Verfahren hergestellt sind, sind besonders für den Einsatz in einem Tiegelziehverfahren für Quarzglas geeignet, da es hierbei auf die Gasdichtheit ankommt.

Durch das Dichtmittel bildet sich nach Einwirkung einer Temperatur größer 1500°C eine Mischphase aus dem Material des Dichtmittels und dem Refraktärmetall an den Kontaktflächen der Wandteile aus. Es wird damit eine Gasdichtigkeit an den Fügestellen erreicht, so dass das Eindringen verunreinigter oder feuchter Gase während des Sinterns der Wandteile und während des Betriebs des Bauteils verhindert wird. Die Dichtwirkung zwischen den Einzelteilen des Bauteils setzt bereits vor deren Versinterung ein, so dass das Versintern der Wandteile nach dem erfindungsgemäßen Verfahren schneller als nach der konventionellen Methode ohne ein Dichtmittel erfolgt, da kein Gas, insbesondere kein Sauerstoff, an die Kontaktflächen der Wandteile gelangen kann. Es ist ausreichend, wenn das Dichtmittel nur von der Außenseite in die Fuge der auf Stoß aneinander gesetzten Wandteile eingelegt wird, und dabei nur einen geringen Anteil der gesamten Wandungsdicke der Einzelteile belegt.

Besonders geeignet im erfindungsgemäßen Verfahren ist ein Dichtmittel aus Hafnium, Niob oder Zirkonium oder aus einer Legierung mit Hafnium, Niob oder Zirkonium als Basiselement. Dichtmittel aus diesen Metallen oder Metalllegierungen bilden im Kontakt mit dem Refraktärmetall der Wandteile besonders leicht eine Mischphase aus. Reines Hafnium als Dichtmittel bildet mit Wandteilen aus Wolfram eine Hafnium-Wolfram-Legierung aus, die das Versintern der Wandteile begünstigt. Als Dichtmittel können auch Legierungen aus den drei Elementen Hafnium, Niob und Zirkonium eingesetzt werden, wichtig dabei sind aber neben der Verarbeitbarkeit als Dichtmittel die Korrosionsbeständigkeit gegenüber oxidativen Schmelzen und die mechanischen Eigenschaften wie etwa die Duktilität. Unvermeidbare weitere Elemente können in den Legierungen als Verunreinigungen in geringem Umfang akzeptiert werden, grundsätzlich ist aber eine hohe Reinheit anzustreben, um eine mögliche Ausbildung von spröden, keramischen Mischphasen, insbesondere Karbiden, zu vermeiden, die die Versinterung der Wandteile behindern können.

Im Hinblick auf das Sinterverhalten hat es sich als besonders günstig erwiesen, wenn das Dichtmittel ein Hafnium-Wolfram-Legierung mit einem Hafnium-Anteil von 78 Gew.-% umfasst. Diese Legierungszusammensetzung zeigt gemäß dem Wolfram- Hafnium-Phasendiagramm einen Schmelzpunkt von etwa 1950°C. Somit erweicht das Dichtmittel bei einer entsprechenden Sintertemperatur und kann die Fuge zwischen den Wandteile lückenlos ausfüllen und gasdicht verschließen.

Alternativ zu Hafnium, Niob oder Zirkonium oder zu Legierung dieser Elemente kann auch ein Dichtmittel aus Platin oder aus einer Platinlegierung verwendet werden. Wenn Platin oder eine Platinlegierung als Dichtmittel eingesetzt werden, muss mit höheren Materialkosten als beim Einsatz der unedlen, hochschmelzenden Metalle wie etwa Hafnium, Niob oder Zirkonium gerechnet werden. Als Dichtmittel im Sinne der Erfindung sind Platin und Platinlegierungen jedoch gleichermaßen wie Hafnium, Niob und Zirkonium geeignet. Als Platinlegierung haben sich Platin-Wolfram-Legierungen bewährt, die je nach Wolfram-Anteil einem Schmelzbereich zwischen etwa 1850°C und 1910°C haben.

Als Material für die Wandteile haben sich Wolfram oder Molybdän oder eine Wolfram- oder Molydbän-Basislegierung bewährt. Diese Refraktärmetalle zeigen einen hohen Schmelzpunkt, relativ niedrige Wärmeausdehnung und eine vergleichsweise hohe Leitfähigkeit für Wärme und Strom, so dass sie als Werkstoff für den Einsatz bei hohen Temperaturen, insbesondere für die Herstellung von Schmelztiegeln für Quarzglas, gut geeignet sind.

In einer Variante des erfindungsgemäßen Verfahrens weist die Fuge zwischen den auf Stoß aneinander gesetzten Wandteilen eine Nut auf, in die das Dichtmittel eingefügt wird. Dabei werden die Stoßflächen der einzelnen Wandteile mit einer Vertiefung in Form einer Nut versehen, in die dann das Dichtmittel vor dem Aneinanderfügen der Wandteile eingelegt wird. Hierdurch wird das Dichtmittel in seiner Position besonders gut fixiert und kann bei Erschütterung, - zum Beispiel beim Umsetzen der noch lose aneinander gefügten Wandteile -, noch vor dem Versintern der Einzelteile nicht verloren gehen.

In Bezug auf das Dichtmittel wird in einer bevorzugten Variante des erfindungsgemäßen Verfahrens dieses in Form eines Konstruktionsbauteils eingefügt. Als Konstruktionsbauteil wird ein Fertigteil in zusammenhängender, geometrischer Form verstanden. Diese Form des Dichtmittels hat den Vorteil, dass keine Zusatzstoffe, die etwa die Haftung oder die Fließfähigkeit des Dichtmittels beeinflussen, in die Fügestelle eingebracht werden und so dort potenziell Quelle von Verunreinigungen sind.

Besonders bewährt hat sich das Dichtmittel in Form eines Drahtes einzufügen. Als Ausführungsform für den Draht hat sich ein Draht mit einem Rundprofil und mit einem Drahtdurchmesser im Bereich von 0,1 mm bis 1,0 mm bewährt.

Gleichermaßen vorteilhaft ist es, wenn ein Draht mit einem Polygonprofil, vorzugsweise mit einem Dreiecksprofil, eingefügt wird. Runde oder eckige Drahtprofile sind Standardformen, die in verschiedenen Abmessungen handelsüblich sind. Durch das Einfügen des Dichtmittels in Form eines Drahtes ist kein wesentlicher zusätzlicher Aufwand bei der Herstellung des Bauteils nötig.

Gleiches gilt auch für die alternative und gleichermaßen bevorzugte Verfahrensvariante, bei der das Dichtmittel in Form einer Folie mit einer Foliendicke im Bereich von 0,05 mm bis 0,5 mm eingefügt wird. Auch Folien, beispielsweise aus Hafnium sind handelsübliche Konstruktionsbauteile. Unter Folien im Sinne der Erfindung werden auch dünne Bleche verstanden.

Hinsichtlich des Bauteils wird die oben genannte Aufgabe ausgehend von einem Bauteil der eingangs genannten Gattung erfindungsgemäß dadurch gelöst, dass die Fuge durch ein Dichtmittel gasdicht geschlossen ist.

Bei dem erfindungsgemäßen Bauteil handelt es sich um einen Gegenstand, der beim Ziehprozess mit SiO₂ in Kontakt kommt. Als Beispiel seien der Schmelztiegel und dessen Bestandteile genannt, wie Düsen oder Düsenhalterungen, oder in die Quarzglasmasse hinein ragende Rohre zur Gaszufuhr, Hüllkörper für Messeinrichtungen oder Mischvorrichtungen. Die Arbeitstemperatur beim bestimmungsgemäßen Einsatz des Bauteils liegt deutlich oberhalb von 2000 °C, in der Regel im Temperaturbereich zwischen 2050°C und 2300°C. Die Wandungen des Bauteils bestehen im Wesentlichen aus hochtemperaturbeständigen Metallen, wie etwa Wolfram, wobei außer Wolfram auch Niob, Molybdän und Tantal in Betracht kommen. Durch das Einfügen eines Dichtmittels aus der Gruppe Hafnium, Niob, Zirkonium oder aus einer Legierung mit dem Basiselement Hafnium, Niob oder Zirkonium oder durch das Einfügen eines Dichtmittels aus Platin oder aus einer Platinlegierung wird die Fuge zwischen den auf Stoß aneinander gesetzten Wandteilen schon vor dem Versintern gasdicht abgeschlossen, so dass das Eindringen verunreinigter oder feuchter Gase während des Sinterns der Einzelteile und während des Betriebs des Bauteils verhindert wird.

Das erfindungsgemäße Bauteil ist somit für einen Einsatz bei hoher Arbeitstemperatur in einem Tiegelziehverfahren für Quarzglas optimiert.

### Ausführungsbeispiel

Nachfolgend wird die Erfindung anhand einer Patentzeichnung und eines Ausführungsbeispiels näher erläutert. Im Einzelnen zeigt:
- **Figur 1a, 1b**: eine schematische Querschnittsdarstellung zweier, auf Stoß aneinander gesetzter Wandteile mit einem als Draht eingefügten Dichtmittel in der Fuge,
- **Figur 1c**: eine schematische Querschnittsdarstellung zweier, auf Stoß aneinander gesetzter Wandteile mit einem als Folie eingefügten Dichtmittel in der Fuge,
- **Figur 2**: einen Ausschnitt aus dem Phasendiagramm des 2-Komponentensystems Wolfram - Hafnium.

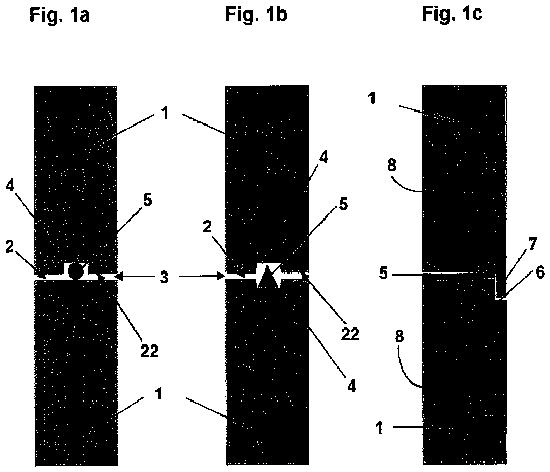

In den Figuren 1a und 1b wird jeweils in einer schematischen Darstellung ein Querschnittsausschnitt einer Schmelztiegelwandung aus Wolfram gezeigt, der nach dem erfindungsgemäßen Verfahren aus mindestens zwei einzelnen Wandteilen 1 aus einem Refraktärmetall, - hier Wolfram -, zusammengefügt wird. Die Stoßflächen 2, 22 der Wandteile 1 werden unter Bildung einer Fuge 3 aneinander gesetzt. Gemäß Figur 1 a ist eine der beiden Stoßflächen 2 gerade und glatt ausgeführt, die andere Stoßfläche 22 hat eine Kontur in Form einer rechteckigen Nut 4. In diese Nut 4 ist als Dichtmittel 5 ein Hafnium-Draht mit Rundprofil eingelegt und durch die Nut 4 fixiert. Der Hafnium-Draht hat einen Durchmesser von 0,8 mm und ragt etwas über die weniger als 0,8 mm tiefe Nut 4 hinaus. Die Wandteile 1 werden nun an ihren Stoßflächen 2, 22 aneinander gefügt, wodurch der Hafnium-Draht sich verformt, dabei die Nut 4 ausfüllt und so die Stöße der Wolfram-Wandteile abdichtet. Beim Aufheizen der Wandteile während des Schmelzbetriebs von Quarzglas auf Temperaturen im Bereich von über 2000°C bildet sich an den Verbindungsstellen eine Wolfram-Hafnium-Phase aus, die die Versinterung der Wandteile 1 unterstützt und somit gewährleistet, dass kein Gas mehr, - insbesondere kein Sauerstoff - den Stoß durchströmt.

Gemäß Figur 1b haben beide Stoßflächen 2, 22 der Wandteile 1 in gleicher Position jeweils eine Nut 4, die beim Stoß-an-Stoß-Aneinanderfügen der Wandteile überlappen unter Ausbildung einer Fuge 3 mit einem Hohlraum im Innern der Verbindungsstelle, in den in diesem Fall ein Hafnium-Draht mit einem Dreiecksprofil als Dichtmittel 5 eingefügt ist. Beim Aneinanderpressen der Stoßflächen 2, 22 wird zunächst ohne großen Kraftaufwand die Spitze des dreieckigen Drahtes, dann auch die Basis des Drahtes verformt und füllt so die Nut 4 aus. Somit bildet der verformte Draht schon ohne Einwirkung erhöhter Temperatur eine Dichtung in der Fuge 3.

Alternativ zu den Ausführungen gemäß Figur 1 a und 1b zeigt Figur 1c zwei Wandteile 1 mit einer formschlüssigen Kontur der Stoßflächen 2, 22. Die beiden Stoßflächen 2, 22 haben einen Absatz 6 bzw. einen Vorsprung 7, die ineinander greifen und dabei die beiden Wandteile 1 zueinander zentrieren. In die entstehende Fuge 3 zwischen den Stoßflächen 2, 22 ist von der Außenseite 8 der Wandteilen 1 her ein Folienpaket aus mehrere dünnen Hafnium Folien mit Foliendicken im Bereich von 0,05 mm bis 0,3 mm eingefügt. Durch Aneinanderfügen der Wandteile 1 bildet die Folie bzw. das Folienpaket eine Dichtung zwischen den Wandteilen 1 aus, die beim anschließenden Aufheizen die Versinterung der Wandteile unterstützt.

Anstelle des Drahtes oder der Folie aus reinem Hafnium kann alternativ ein Draht oder eine Folie aus einer Hafnium-Wolfram-Legierung mit einem Hafnium-Anteil von 78 Gew.% als Dichtmittel verwendet werden.

In analoger Weise wirkt auch ein Dichtmittel 5, das in Form eines Platin-Drahtes zwischen die Stoßflächen 2, 22 eingelegt wird.

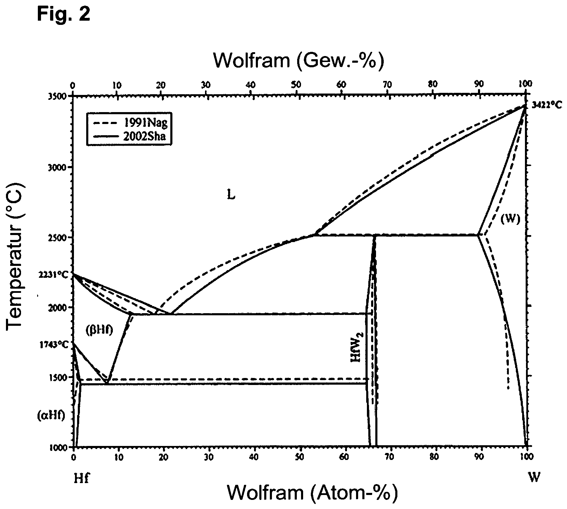

Das Phasendiagramm des 2-Komponentensystems Wolfram - Hafnium gemäß **Figur 2** stammt aus Phase Diagrams of Binary Tungsten Alloys, S.V. Nagender Naidu, Indian Institute of Metals, 1991, p 114-121, G. Shao, Thermodynamic Assessment of the Hf-Mo and Hf-W Systems, Intermetallics, Vol 10 (No. 5), 2002, p 429-434. Die beiden Autoren Nagender (abgekürzt Nag, gestrichelte Linie) und Shao (abgekürzt Sha, durchgezogene Linie) haben in getrennten Messungen ein im Wesentlichen übereinstimmendes Phasendiagramm ermittelt. Auf der unteren X-Achse ist der Wolfram- bzw. Hafnium-Gehalt in Atom-% (At.-%) und auf der oberen X-Achse in Gewichts-% (Gew.-%) aufgetragen. Im Temperaturbereich zwischen 1900°C und 2500 °C ist eine W-Hf-Legierung mit einer Schmelztemperatur von etwa 1950°C thermodynamisch stabil, die einen Anteil von 78 Gew.-% Hafnium hat. Beim Versintern der auf Stoß aneinander gefügten Wandteile 1 aus Wolfram mit Hilfe des Dichtmittels 5 aus Hafnium entsteht an der Fügestelle eine Wolfram-Hafnium-Mischphase. Bei Einsatz einer Hafnium-Wolfram-Legierung als Dichtmittel 5 diffundiert beim Versintern Wolfram aus den Wandteilen 1 in die Hafnium-Wolfram-Mischphase des Dichtmittels 5 ein. Die erforderliche Temperatur zur Versinterung steigt damit geringfügig. Gleichzeitig steigt aber auch die Temperaturbeständigkeit des in dieser Weise hergestellten Bauteils.

## Patentansprüche

1. Verfahren zur Herstellung eines Bauteils durch Fügen von Wandteilen - insbesondere zur Herstellung eines Schmelztiegels für den Einsatz bei hoher Arbeitstemperatur in einem Tiegelziehverfahren für Quarzglas -, indem mindestens zwei Wandteile(1) aus einem Refraktärmetall oder aus einer Basislegierung eines Refraktärmetalls bereitgestellt, unter Bildung einer Fuge (3) auf Stoß aneinander gesetzt und bei einer Temperatur oberhalb von 1500°C zu dem Bauteil durch Sintern zusammen gefügt werden, **dadurch gekennzeichnet, dass** ein Dichtmittel (5) in die Fuge (3) eingefügt wird.

2. Verfahren nach Anspruch 1, **dadurch gekennzeichnet, dass** ein Dichtmittel (5) aus Hafnium, Niob, oder Zirkonium oder aus einer Legierung mit Hafnium, Niob oder Zirkonium als Basiselement in die Fuge (3) eingefügt wird.

3. Verfahren nach Anspruch 1 oder 2, **dadurch gekennzeichnet, dass** das Dichtmittel (5) eine Wolfram-Hafnium-Legierung umfasst mit einem Hafnium-Anteil von 78 Gew.-%.

4. Verfahren nach Anspruch 1, **dadurch gekennzeichnet, dass** ein Dichtmittel (5) aus Platin oder aus einer Platinlegierung in die Fuge (3) eingefügt wird.

5. Verfahren nach einem der vorhergehenden Ansprüche, **dadurch gekennzeichnet, dass** die Fuge (3) zwischen den auf Stoß aneinander gesetzten Wandteilen (1) eine Nut (4) aufweist, in die das Dichtmittel (5) eingefügt wird.

6. Verfahren nach einem der vorhergehenden Ansprüche, **dadurch gekennzeichnet, dass** das Dichtmittel (5) in Form eines Konstruktionsbauteils eingefügt wird.

7. Verfahren nach einem der vorhergehenden Ansprüche, **dadurch gekennzeichnet, dass** das Dichtmittel (5) in Form eines Drahtes eingefügt wird.

8. Verfahren nach Anspruch 7, **dadurch gekennzeichnet, dass** ein Draht mit einem Rundprofil und mit einem Drahtdurchmesser im Bereich von 0,1 mm bis 1,0 mm eingefügt wird.

9. Verfahren nach Anspruch 7, **dadurch gekennzeichnet, dass** ein Draht mit einem Polygonprofil, vorzugsweise mit einem Dreiecksprofil, eingefügt wird.

10. Verfahren nach einem der Ansprüche 1 bis 6, **dadurch gekennzeichnet, dass** das Dichtmittel (5) in Form einer Folie mit einer Foliendicke im Bereich von 0,05 mm bis 0,5 mm eingefügt wird.

11. Verfahren nach einem der vorhergehenden Ansprüche, **dadurch gekennzeichnet, dass** als Refraktärmetall für die Wandteile (1) Wolfram oder Molybdän oder eine Wolfram- oder Molydbän-Basislegierung eingesetzt wird.

12. Bauteil, insbesondere Schmelztiegel, insbesondere für ein Tiegelziehverfahren für Quarzglas, das mindestens zwei Wandteile (1) aus einem Refraktärmetall oder aus einer Basislegierung eines Refraktärmetalls aufweist, welche unter Bildung einer Fuge (3) auf Stoß aneinander gesetzt sind, **dadurch gekennzeichnet, dass** die Fuge (3) durch ein Dichtmittel (5) gasdicht geschlossen ist.

13. Bauteil nach Anspruch 12, **dadurch gekennzeichnet, dass** die Fuge (3) durch ein Dichtmittel (5) aus Hafnium, Niob, oder Zirkonium oder aus einer Legierung mit Hafnium, Niob oder Zirkonium als Basiselement geschlossen ist.

14. Bauteil Anspruch 12 oder 13, **dadurch gekennzeichnet, dass** die Fuge (3) durch ein Dichtmittel (5) aus einer Wolfram-Hafnium-Legierung mit einem Hafnium-Anteil von 78 Gew.-% geschlossen ist.

15. Bauteil nach einem der Ansprüche 12 bis 14, **dadurch gekennzeichnet, dass** als Refraktärmetall Wolfram oder Molybdän oder eine Wolfram- oder Molydbän-Basislegierung eingesetzt ist.

16. Bauteil nach Anspruch 12, **dadurch gekennzeichnet, dass** die Fuge (3) durch ein Dichtmittel (5) aus Platin oder aus einer Platinlegierung geschlossen ist.

## Claims

1. A method for producing a component by joining wall parts - especially for producing a crucible for use at a high operating temperature in a crucible pulling method for quartz glass, in that at least two wall parts (1) of a refractory metal or of a base alloy of a refractory metal are provided, butt-joined to form a joint (3) and joined together by sintering at a temperature above 1500°C to form the component, **characterized in that** a sealant (5) is inserted into the joint (3).

2. The method according to claim 1, **characterized in that** a sealant (5) of hafnium, niobium or zirconium or of an alloy with hafnium, niobium or zirconium as the base element is inserted into the joint (3).

3. The method according to claim 1 or 2, **characterized in that** the sealant (5) comprises a tungsten-hafnium alloy with a hafnium amount of 78% by wt.

4. The method according to claim 1, **characterized in that** a sealant (5) of platinum or of a platinum alloy is inserted into the joint (3).

5. The method according to any one of the preceding claims, **characterized in that** the joint (3) between the butt-joined wall parts (1) comprises a groove (4) into which the sealant (5) is inserted.

6. The method according to any one of the preceding claims, **characterized in that** the sealant (5) is inserted in the form of a structural component.

7. The method according to any one of the preceding claims, **characterized in that** the sealant (5) is inserted in the form of a wire.

8. The method according to claim 7, **characterized in that** a wire with a round profile and with a wire diameter in the range of from 0.1 mm to 1.0 mm is inserted.

9. The method according to claim 7, **characterized in that** a wire with a polygonal profile, preferably with a triangular profile, is inserted.

10. The method according to any one of claims 1 to 6, **characterized in that** the sealant (5) is inserted in the form of a film with a film thickness in the range of from 0.05 mm to 0.5 mm.

11. The method according to any one of the preceding claims, **characterized in that** tungsten or molybdenum or a tungsten or molybdenum base alloy is used as the refractory metal for the wall parts (1).

12. A component, particularly crucible, particularly for a crucible pulling method for quartz glass, which comprises at least two wall parts (1) of a refractory metal or of a base alloy of a refractory metal, which are butt-joined to form a joint (3), **characterized in that** the joint (3) is closed in a gas-tight manner by a sealant (5).

13. The component according to claim 12, **characterized in that** the joint (3) is closed by a sealant (5) of hafnium, niobium or zirconium or of an alloy with hafnium, niobium or zirconium as the base element.

14. The component according to claim 12 or 13, **characterized in that** the joint (3) is closed by a sealant (5) of a tungsten-hafnium alloy with a hafnium amount of 78% by wt.

15. The component according to any one of claims 12 to 14, **characterized in that** tungsten or molybdenum or a tungsten or molybdenum base alloy is used as the refractory metal.

16. The component according to claim 12, **characterized in that** the joint (3) is closed by a sealant (5) of platinum or of a platinum alloy.

## Revendications

1. Procédé pour la fabrication d'un composant par assemblage de parties de parois, en particulier pour la fabrication d'un creuset de fusion pour l'emploi à une température de travail élevée dans un procédé d'extraction de creuset pour du verre de quartz, dans lequel au moins deux parties de parois (1) sont préparées en métal réfractaire ou en alliage de base d'un métal réfractaire, sont assemblées bord à bord affleure en formant un joint (3) et sont assemblés par frittage au composant à une température supérieure à 1500 °C, **caractérisé en ce qu'**un moyen d'étanchéité est inséré dans le joint (3).

2. Procédé selon la revendication 1, **caractérisé en ce qu'**un moyen d'étanchéité (5) en hafnium, niobium ou zirconium ou en un alliage avec hafnium, niobium ou zirconium est inséré dans le joint (3) en tant qu'élément de base.

3. Procédé selon la revendication 1 ou 2, **caractérisé en ce qu'**un moyen d'étanchéité (5) comprend un alliage de tungstène et d'hafnium avec une teneur en hafnium de 78 % en poids.

4. Procédé selon la revendication 1, **caractérisé en ce qu'**un moyen d'étanchéité (5) en platine ou un alliage de platine est inséré dans le joint (3).

5. Procédé selon l'une des revendications précédentes, **caractérisé en ce que** les joints (3) présentent une rainure (4) entre les parties de parois (1) jointives bord à bord dans laquelle est introduit le moyen d'étanchéité (5).

6. Procédé selon l'une des revendications précédentes, **caractérisé en ce que** le moyen d'étanchéité (5) est inséré sous forme d'un composant de construction.

7. Procédé selon l'une des revendications précédentes, **caractérisé en ce que** le moyen d'étanchéité (5) est inséré sous forme d'un fil.

8. Procédé selon la revendication 7, **caractérisé en ce qu'**un fil avec un profil rond est inséré avec un diamètre de 0,1 mm à 1,0 mm.

9. Procédé selon la revendication 7, **caractérisé en ce qu'**un fil avec un profil polygonale est inséré, de préférence un fil avec un profilé triangulaire.

10. Procédé selon l'une des revendications 1 à 6, **caractérisé en ce que** le moyen d'étanchéité (5) est inséré sous forme une feuille avec un épaisseur de 0.05 mm à 0.5 mm.

11. Procédé selon l'une des revendications précédentes, **caractérisé en ce que** en tant que le métal réfractaire pour les parties de parois (1) est le tungstène ou le molybdène ou un alliage de tungstène ou de molybdène.

12. Composant en particulier un creuset de fusion pour l'emploi dans un procédé d'extraction de creuset pour du verre de quartz, dans lequel au moins deux parties de parois (1) sont préparées en métal réfractaire ou présentent un alliage de base d'un métal réfractaire, qui est assemblée bord à bord affleures en formant un joint (3), **caractérisé en ce que** le joint (3) est fermée par un moyen d'étanchéité (5) contre le gaz.

13. Composant selon la revendication 12, **caractérisé en ce que** le joint (3) est fermé par un moyen d'étanchéité (5) en hafnium, niobium , ou zirconium ou un alliage avec hafnium, niobium ou zirconium en tant qu'élément de base.

14. Composant selon la revendication 12 ou 13, **caractérisé en ce que** le joint (3) est fermé par un alliage de tungstène et de hafnium avec une teneur en hafnium de 78 % en poids.

15. Composant selon l'une des revendications 12 à 14, **caractérisé en ce que** en tant que le métal réfractaire tungstène ou molybdène ou un alliage de base en tungstène ou molybdène est utilisé.

16. Composant selon la revendication 12, **caractérisé en ce que** le joint (3) est fermé par un moyen d'étanchéité (5) en platine ou un alliage de platine.
